# EUROPEAN PATENT APPLICATION

(11) **EP 4 650 706 A1**
(43) Date of publication of application: **19.11.2025**
(21) Application number: 24386054.1
(22) Date of filing: 14.05.2024
(51) Int. Cl.: G01B 9/02, G01S 7/4912, H01S 5/00

(54) **SELF MIXING INTERFEROMETRIC SENSOR AND METHOD FOR DETECTING A MOTION OF A MOVING TARGET**

(71) Applicant: ams-OSRAM International GmbH, 93055 Regensberg (DE)
(72) Inventor: Grimau, Marcelli, 8134 Adliswil (CH); Sánchez, Javier Miguel, 8046 Zürich (CH); Rossi, Nicola, 8803 Rueschlikon (CH); D'Aleo, Francesco Paolo, 8833 Samstagem (CH); Katsikatsos, Giorgos, 8037 Zürich (CH); Debout, Quentin, 8055 Zürich (CH); Bougrine, Anis, 8134 Adliswil (CH)
(74) Representative: Epping - Hermann - Fischer

(57) **Abstract**

A self-mixing interferometric sensor with the following features is provided:
- a VCSEL (1) having two radiation transmission surfaces (6) and being configured for emitting undistorted electromagnetic radiation (13) of an undistorted frequency (v₀) in an undistorted operation mode and configured for emitting distorted electromagnetic radiation (14) with a frequency variation in a distorted operation mode, and
- an optical element (10) on or over one of the radiation transmission surfaces (6), wherein
- the optical element (10) transmits distorted electromagnetic radiation (14) and blocks undistorted electromagnetic radiation (13), and/or
- the optical element (10) splits passing distorted electromagnetic radiation (14) in at least two beams (14') dependent on the frequency.

Further, a method for detecting a motion of a moving target is provided.

## Description

A self-mixing interferometric sensor and a method for detecting a motion of a moving target are provided.

It is an object to provide an improved self-mixing interferometric sensor. Particularly, a self-mixing interferometric sensor with improved signal quality and/or improved signal strength is to be provided. Further, an improved method for detecting a motion of a moving target, particularly with improved reliability, is to be provided.

These objects are achieved with a self-mixing interferometric sensor having the features of claim 1 and a method having the steps of claim 13.

Improved developments and embodiments of the self-mixing interferometric sensor and the method for detecting a motion of a moving target are given in the dependent claims.

The self-mixing interferometric sensor is, particularly, configured for self-mixing interferometry (short: SMI). Self-mixing interferometry is an interferometric technique, wherein electromagnetic radiation of an output beam emitted by a laser device such as a VCSEL (short for "*vertical cavity surface emitting laser"*), is reflected back into an optical cavity of the laser device, causing a modulation and/or variation of an amplitude and/or a frequency of the electromagnetic radiation of the output beam. Particularly, the active zone used as an active laser medium of the VCSEL exhibits strong variation, for example of gain and refractive index, when electromagnetic radiation of the VCSEL reflected from the moving target reaches the optical cavity of the VCSEL. This produces a modulation of the amplitude and a modulation of the frequency of the electromagnetic radiation emitted by the VCSEL. This makes the laser device sensitive to the distance travelled by the electromagnetic radiation reflected by the external moving target. Therefore, a distance, velocity, vibration and/or movement of the external target reflecting the electromagnetic radiation can be derived from the amplitude modulation and/or frequency modulation. Particularly, self-mixing interferometry has the advantage that collimating optics and/or external photodiodes can be omitted for distance and/or movement measurement. For example, the laser device is a self-mixing interferometric sensor.

According to an embodiment, the self-mixing interferometric sensor comprises a VCSEL having two radiation transmission surfaces and being configured for emitting undistorted electromagnetic radiation of an undistorted frequency in an undistorted operation mode and configured for emitting distorted electromagnetic radiation with a frequency variation in a distorted operation mode. For example, the frequency variation in the distorted operation mode is a frequency modulation.

The VCSEL, particularly, comprises an epitaxial semiconductor layer sequence having an active zone configured for generation of electromagnetic radiation during operation. The epitaxial semiconductor layer sequence extends in a main extension plane perpendicular to a growth direction of the epitaxial semiconductor layer sequence. The active zone is, particularly, a laser active medium of the VCSEL. Further, the VCSEL comprises an optical cavity wherein the active laser medium, such as the active zone, is arranged. The optical cavity is, for example, formed by two oppositely arranged mirrors reflecting the electromagnetic radiation generated within the active zone at least partially. The mirrors are, for example, distributed Bragg reflectors applied to oppositely arranged main surfaces of the epitaxial semiconductor layer sequence. Particularly, the main extension plane of the mirrors, as well as a main extension plane of the active zone, run parallel to each other and to the radiation transmission surfaces of the VCSEL. Particularly, the electromagnetic radiation emitted or transmitted by the radiation transmission surface of the VCSEL runs parallel to a growth direction of the epitaxial semiconductor layer sequence. For example, the VCSEL is a VCSEL chip comprising or consisting of a semiconductor material.

Particularly, the VCSEL is a two-side-emitting VCSEL with two radiation transmission surfaces configured for transmitting electromagnetic radiation. Particularly, both radiation transmission surfaces run parallel to each other and are arranged opposite to each other. For example, the two radiation transmission surfaces are achieved with partially transmitting mirrors forming the optical cavity of the VCSEL.

Particularly one of the two radiation transmission surfaces of the VCSEL faces a field of view of the self-mixing interferometric sensor and limits the field of view of the self-mixing interferometric sensor, while the other radiation transmission surface of the VCSEL faces a detector configured for detecting electromagnetic radiation and particularly configured for detecting distorted electromagnetic radiation passing the optical element.

Particularly, the VCSEL can be operated in an undistorted operation mode and a distorted operation mode being different from each other. In the undistorted operation mode, undistorted electromagnetic radiation having an undistorted frequency is emitted by the VCSEL. Particularly, during the undistorted operation mode no moving target is arranged in the field of view of the self-mixing interferometric sensor and no electromagnetic radiation is reflected back in the optical cavity of the VCSEL leading to a modulation of the amplitude and/or the frequency of the electromagnetic radiation.

In the distorted operation mode, the moving target with the motion to be detected is in the field of view of the self-mixing interferometric sensor and reflects the electromagnetic radiation emitted by the VCSEL back into the optical cavity of the VCSEL leading to a modulation of the amplitude and/or the frequency of the electromagnetic radiation. The modulated frequency of the electromagnetic radiation due to the moving target has a variation in frequency. In other words, the presence of a moving target within the field of view of the self-mixing interferometric sensor leads to a variation of the amplitude and/or the frequency of the electromagnetic radiation emitted by the VCSEL. Particularly, the frequency varies during the distorted operation mode leading to the frequency variation. In other words, the electromagnetic radiation has a varying frequency during the distorted operation mode.

According to a further embodiment, the self-mixing interferometric sensor further comprises an optical element on or over one of the radiation transmission surfaces, the optical element transmits distorted electromagnetic radiation and blocks undistorted electromagnetic radiation. For example, the optical element absorbs some or all undistorted electromagnetic radiation.

According to a further embodiment of the self-mixing interferometric sensor, the optical element splits the passing distorted electromagnetic radiation into at least two beams dependent on the frequency. Particularly, the optical element splits an incoming beam of distorted electromagnetic radiation into at least two spatially separated beams of distorted electromagnetic radiation dependent on the frequency. For example, a volume phase hologram can be used in this embodiment as the optical element.

According to an embodiment, the self-mixing interferometric sensor comprises the VCSEL having the two radiation transmission surfaces. The VCSEL is configured for emitting the undistorted electromagnetic radiation of the undistorted frequency in the undistorted operation mode and is further configured for emitting the distorted electromagnetic radiation with the frequency variation in a distorted operation mode. Further, the self-mixing interferometric sensor comprises the optical element on or over one of the radiation transmission surfaces, the optical element transmits the distorted electromagnetic radiation and blocks undistorted electromagnetic radiation and/or splits passing distorted electromagnetic radiation in at least two beams dependent on the frequency.

The self-mixing interferometric sensor is *inter alia* based on the idea of converting the frequency modulation of the distorted electromagnetic radiation caused by the motion of the moving target in an intensity signal, which can be detected with a detector. Particularly, the modulation of the amplitude of the electromagnetic radiation due to a moving target reflecting electromagnetic radiation back in the optical cavity of the VCSEL can be detected directly, for example with the help of a photodiode. However, the frequency modulation of the distorted electromagnetic radiation due to the motion of the moving target is not directly accessible for a detector. At present, the variation in the frequency of the distorted electromagnetic radiation is converted in an intensity signal by the optical element. By generating an additional signal due to the frequency modulation caused by the moving target, the signal strength and/or the signal quality of the self-mixing interferometric sensor can be strongly enhanced and reliability of a method using the self-mixing interferometric sensor can be improved. It is also possible that an optical element splits the distorted electromagnetic radiation of the VCSEL different beams dependent on the frequency.

According to a further embodiment of the self-mixing interferometric sensor, the optical element transmits electromagnetic radiation with a frequency smaller than a frequency of a blocking edge and blocks, particularly absorbs, electromagnetic radiation with a frequency larger than the frequency of the blocking edge or vice versa. Particularly, the blocking edge is part of a transmission spectrum of the optical element, the transmission spectrum characterizing transmission properties and blocking properties of the optical element.

The blocking edge, particularly, has a slope connecting a transmission region of the transmission spectrum of the optical element with a blocking region of the transmission spectrum. Particularly, electromagnetic radiation with frequencies in the transmission region are transmitted at least partially by the optical element, while electromagnetic radiation with frequencies in the blocking region of the optical element is blocked, for example absorbed, at least partially by the optical element. The slope of the blocking edge determines the conversion of the frequency modulation of the distorted electromagnetic radiation in an intensity modulation. The steeper the slope of the blocking edge, the greater the modulation of the intensity. Consequently, a blocking edge with a very steep slope is advantageous. Particularly, the slope runs through a transition region between the transmission region and the blocking region of the transmission spectrum.

Particularly, the undistorted frequency of the undistorted electromagnetic radiation is aligned with the blocking edge. Particularly, the undistorted frequency of the undistorted electromagnetic radiation corresponds to a frequency of the slope of the blocking edge. In other words, the undistorted frequency is a frequency of a point of the slope of the blocking edge of the transmission spectrum. In a theoretical ideal case, the slope of the blocking edge runs perpendicular at a single edge frequency and the undistorted frequency is the same as the edge frequency, for example. For example, the undistorted frequency is a mean value around which the variation of the frequency oscillates in the distorted operation mode.

According to a further embodiment of the self-mixing interferometric sensor, the transmission spectrum of the optical element has a further blocking edge and the region between the blocking edge and the further blocking edge forms the transmission region of the optical element for distorted electromagnetic radiation with a frequency variation. In other words, the transmission spectrum of the optical element has a transmission region limited by both blocking edges. Electromagnetic radiation with frequencies within the transmission region is transmitted by the optical element, while electromagnetic radiation with frequencies outside the transmission region are blocked by the optical element, for example by absorption. Particularly, the optical element having a transmission spectrum limited by both absorption edges is a band pass filter.

For example, the optical element is a diffractive optical element diffracting electromagnetic radiation, particularly distorted electromagnetic radiation. Particularly, the optical element is chosen from the following group: Fabry-Perot interferometer, metasurface, volume phase hologram, interference filter, diffractive optical element.

The Fabry-Perot interferometer is, particularly, an optical resonator formed by two partially transmitting mirrors. Electromagnetic radiation is only transmitted by the Fabry-Perot interferometer, if it meets the resonance conditions of the optical resonator.

A metasurface is, particularly, an optically active surface configured for controlling impinging electromagnetic radiation in a desired manner.

The metasurfaces is, for example, configured for shifting the phases of the impinging electromagnetic radiation and/or changing its frequency, its amplitude and/or its polarization. For example, a metasurface can act as a planar lens, illumination lens, a planar hologram, a vortex generator, and/or a beam deflector. Particularly, the metasurface is configured for blocking, absorbing, concentrating, dispersing and/or guiding impinging electromagnetic radiation. The metasurface has, for example, a periodic structure with dimensions in the region of the wavelengths of the electromagnetic radiation to be influenced by the metasurface. The periodic structure of the metasurface can extend in a vertical direction perpendicular to a main extension plane of the metasurface or within a horizontal direction parallel to the main extension plane of the metasurface.

The volume phase hologram, particularly, comprises an optical structure influencing, impinging and/or passing electromagnetic radiation. Particularly, the impact of the active optical structure of the volume phase hologram on the electromagnetic radiation is only Bragg diffraction. For example, the volume phase hologram is a dielectric plate, for example a plastic plate, with the optical structure arranged within the volume of the plastic plate. It is also possible that the volume phase hologram has structured surfaces. For example, the volume phase hologram comprises or consists of a grating. For example, a volume phase hologram splits an incoming beam of electromagnetic radiation into different beams, depending on its frequency. For example, the optical structure of the volume phase hologram is a phase element.

The interference filter transmits, absorbs and/or reflects incoming electromagnetic radiation dependent on its frequency, particularly. For example, the interference filter comprises or consists of at least two, particularly of a plurality, of dielectric layers with a defined thickness to achieve an interference effect acting on impinging electromagnetic radiation.

According to a further embodiment of the self-mixing interferometric sensor, the optical element is applied to one of the radiation transmission surfaces of the VCSEL. For example, the optical element is in direct contact with the radiation transmission surface of the VCSEL and has, particularly, a common interface with the radiation transmission surface of the VCSEL. Particularly, the optical element is applied to the radiation transmission surface of the VCSEL facing away from the field of view of the self-mixing interferometric sensor. For example, the optical element is a plate with a main extension plane and is applied to the transmission surface of the VCSEL such that its main extension plane is parallel to the main extension plane of the VCSEL. For example, the optical element is grown on the radiation transmission surface of the VCSEL and monolithically integrated with the VCSEL.

According to a further embodiment of the self-mixing interferometric sensor, the optical element comprises two diffractive Bragg reflectors applied to one of the radiation transmission surfaces of the VCSEL. Particularly, the two diffractive Bragg reflectors form a Fabry-Perot interferometer. For example, the two diffractive Bragg reflectors comprise a plurality of alternating layers deposited on each other on the radiation transmission surface of the VCSEL.

According to a further embodiment of the self-mixing interferometric sensor, the two diffractive Bragg reflectors forming the Fabry-Perot interferometer are epitaxially grown on a buffer layer arranged on a further diffractive Bragg reflector partially forming the optical cavity of the VCSEL. In other words, the buffer layer is epitaxially grown on the further diffractive Bragg reflector being part of the VCSEL and forming, together with yet a further diffractive Bragg reflector, the optical cavity of the VCSEL. In other words, the self-mixing interferometric sensor comprises a pair of diffractive Bragg reflectors forming the optical cavity of the VCSEL and being arranged at two oppositely arranged radiation transmissions surfaces of the VCSEL. Particularly, these diffractive Bragg reflectors form the radiation transmission surfaces of the VCSEL. On one of these diffractive Bragg reflectors a buffer layer is applied and on this buffer layer, the diffractive Bragg reflector is arranged being part of the Fabry-Perot interferometer. Particularly, the two diffractive Bragg reflectors forming the Fabry-Perot interferometer are epitaxially grown on the buffer layer. In such a way, the optical element, being a Fabry-Perot interferometer, can be monolithically integrated within the self-mixing interferometric sensor together with the VCSEL.

According to a further embodiment, the self-mixing interferometric sensor further comprises a detector configured for detecting distorted electromagnetic radiation leaving the optical element. Particularly, the detector is arranged on or over a radiation transmission surface of the VCSEL facing away from the field of view of the self-mixing interferometric sensor.

For example, the detector is a photodiode. It is also possible that the photodiode is directly applied to the optical element. For example, the photodiode is expitaxially grown on or over the radiation transmission surface of the VCSEL. For example, the photodiode is expitaxially grown on or over a diffractive Bragg reflector being part of a Fabry-Perot interferometer.

Particularly, if the optical element splits passing distorted electromagnetic radiation in at least two beams dependent on the frequency, the self-mixing interferometric sensor further comprises a spatially resolving detector detecting the distorted electromagnetic radiation in a spatially resolved manner. For example, a photodiode array or a CCD camera (CCD short for: *"charge coupled device"*) is used as a spatially resolving detector.

In the following, a method for detecting a motion of a moving target is described. Particularly, the self-mixing interferometric sensor disclosed herein can be used for carrying out the method for detecting a motion of a moving target. Therefore, all features and embodiments disclosed in connection with the self-mixing interferometric sensor can also be embodied within the method for detecting a motion of the moving target and vice versa.

According to an embodiment of the method for detecting a motion of the moving target, a distorted electromagnetic radiation with a frequency variation is generated within an optical cavity of a VCSEL having two radiation transmission surfaces. Particularly, the distorted electromagnetic radiation is generated due to the motion of the moving target in a distorted operation mode of a self-mixing interferometric sensor. Particularly, the self-mixing interferometric sensor comprises the VCSEL. For example, the frequency variation of the distorted electromagnetic radiation is a modulation of the frequency oscillating around an undistorted frequency of an undistorted electromagnetic radiation of an undistorted operation mode.

Particularly, during the method for detecting the motion of the moving target, the VCSEL emits electromagnetic radiation, which is reflected by the moving target and reaches the optical cavity of the VCSEL by the reflection. Due to the reflected electromagnetic radiation within the optical cavity of the VCSEL, an active laser medium of the VCSEL, such as an active radiation generating zone of an epitaxial semiconductor layer sequence, undergoes variation of its properties such as gain and refractive index. This leads, besides a modulation of the amplitude, particularly to a modulation of the frequency of the electromagnetic radiation emitted by the VCSEL. At present, this is particularly called "distorted operation mode" of the self-mixing interferometric sensor comprising the VCSEL. In other words, in the distorted operation mode a moving target is present within the field of view of the self-mixing interferometric sensor leading to a frequency variation of the electromagnetic radiation emitted by the VCSEL. Further, in the undistorted operation mode of the self-mixing interferometric sensor comprising the VCSEL, the field of view of the self-mixing interferometric sensor is free of the moving target.

According to a further embodiment of the method, an optical element arranged on or over one of the radiation transmission surfaces of the VCSELs transmits the distorted electromagnetic radiation and blocks undistorted electromagnetic radiation of the VCSEL in an undistorted operation mode. Particularly, in the undistorted operation mode the electromagnetic radiation emitted by the VCSEL is not subject to any variation and/or modulation.

According to a further embodiment of the method, the electromagnetic radiation leaving the optical element is detected by a detector.

The self-mixing interferometric sensor as well as the method for detecting a motion of a moving target can find application for optical sensing in an optical microphone, a vibrometer, a LIDAR device (LIDAR short for "light detection and ranging"), a particle detector, a proximity sensor, a force sensor, a gesture sensor and/or in an eye tracking system. Particularly, these devices are intended for the consumer market, for automotive application or domestic robotic applications.

Further advantageous embodiments and developments of the self-mixing interferometric sensor and the method for detecting a motion of a moving target result from the exemplary embodiment described below in connection with the Figures.

Figure 1A shows a schematic sectional view of a self-mixing interferometric sensor according to an exemplary embodiment in an undistorted operation mode.

Figure 1B shows a schematic sectional view of the self-mixing interferometric sensor of Figure 1A in a distorted operation mode.

Figure 2 shows schematically two transmission spectra of an optical element of a self-mixing interferometric sensor according to two exemplary embodiments.

Figure 3 shows a schematic sectional view of a self-mixing interferometric sensor according to a further exemplary embodiment.

Figure 4 shows a schematic sectional view of a self-mixing interferometric sensor according to a further exemplary embodiment.

Figure 5 shows schematically a transmission spectrum of an optical element and an emission spectrum of a VCSEL of the self-mixing interferometric sensor according to the exemplary embodiment of Figure 4.

Figure 6 shows a schematic sectional view of a self-mixing interferometric sensor according to a further exemplary embodiment.

Figure 7 shows schematically a flow diagram of a method for detecting a motion of a moving target according to an exemplary embodiment.

Equal or similar elements as well as elements of equal function are designated with the same reference signs in the Figures. The Figures and the proportions of the elements shown in the Figures are not regarded as being shown to scale. Rather, single elements, in particular layers, can be shown exaggerated in magnitude for the sake of better presentation and/or better understanding.

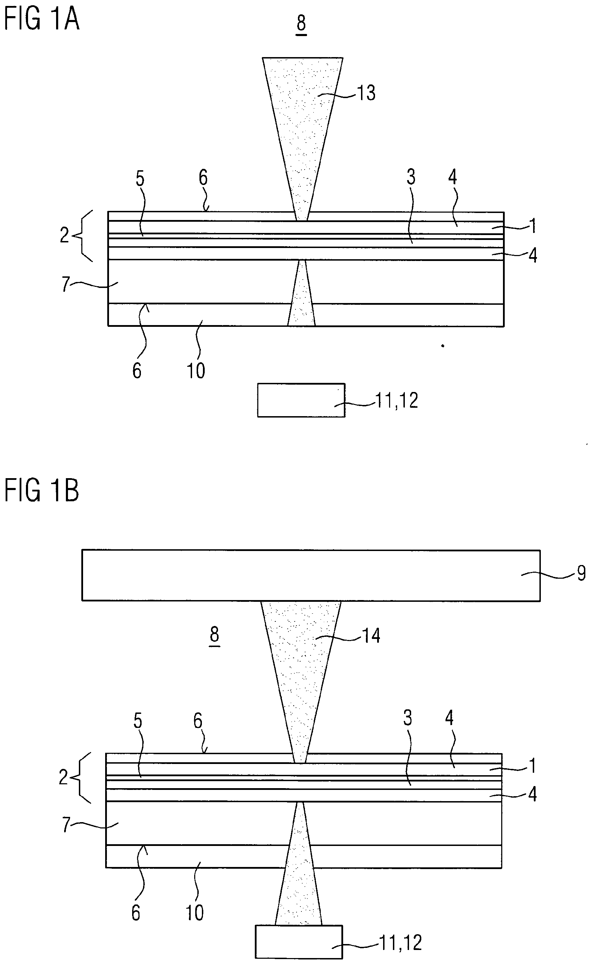

The self-mixing interferometric sensor according to the exemplary embodiment of Figures 1A and 1B comprises a VCSEL 1 with an epitaxial semiconductor layer sequence 2 having an active zone 3 being configured for generating electromagnetic radiation during operation. The epitaxial semiconductor layer sequence 2 is epitaxially grown on a growth substrate 7.

On a first main surface of the epitaxial semiconductor layer sequence 2 and on a second main surface of the epitaxial semiconductor layer sequence 2 opposite to the first main surface, a diffractive Bragg reflector 4 is arranged. Both diffractive Bragg reflectors 4 form an optical cavity 5 of the VCSEL 1. Within the optical cavity 5 of the VCSEL 1, the active zone 3 is arranged as a laser active medium within the optical cavity 5. Particularly, each diffractive Bragg reflector 4 of the optical cavity 5 is semi-transparent for electromagnetic radiation generated within the active zone 3. Therefore, the VCSEL 1 is two-side emitting VCSEL. One diffractive Bragg reflector 4 forming the optical cavity 5 as well as a surface of the growth substrate 7 form radiation transmission surfaces 6 of the VCSEL 1.

One of the radiation transmission surfaces 6 of the VCSEL 1 limits a field of view 8 of the self-mixing interferometric sensor, the field of view 8 being illuminated by the VCSEL 1 during operation. Particularly, the self-mixing interferometric sensor is configured to detect the motion of a moving target 9 arranged within the field of view 8.

Further, the self-mixing interferometric sensor of the exemplary embodiment of Figures 1A and 1B comprises an optical element 10 arranged on or over one of the radiation transmission surfaces 6 of the VCSEL 1. Particularly, the optical element is arranged on a side of the VCSEL 1 facing away from the field of view 8 of the self-mixing interferometer.

Further, the self-mixing interferometric sensor comprises a detector 11 configured for detection of electromagnetic radiation. For example, the detector 11 is a photodiode 12. The detector is arranged at a side of the VCSEL facing away from the field of view.

If the field of view 8 is free of a moving target 10 with a motion to be detected, the self-mixing interferometric sensor is operated in an undistorted operation mode as schematically shown in Figure 1A. In the undistorted operation mode, the VCSEL 1 emits undistorted electromagnetic radiation 13 of an undistorted frequency v₀. Particularly, in the undistorted operation mode no electromagnetic radiation is back-coupled within the optical cavity 5 of the VCSEL 1. The optical element 10 blocks the undistorted electromagnetic radiation 13 of the undistorted frequency ν₀ and the detector 11, such as a photodiode 12, does not detect electromagnetic radiation and does not generate an SMI-signal.

Figure 1B shows the self-mixing interferometric sensor in a distorted operation mode. During the distorted operation mode, a moving target 9 with a motion to be detected is arranged within the field of view 8 of the self-mixing interferometric sensor being illuminated by the VCSEL 1. For example, the motion of the moving target 9 is a shift, a vibration or a rotation. Particularly, the moving target 9 arranged within the field of view 8 of the self-mixing interferometric sensor reflects electromagnetic radiation emitted from the VCSEL 1 of one of the two radiation transmission surfaces 6. The moving target 9 reflects electromagnetic radiation emitted from the radiation transmission surface 6 limiting the field of view 8 of the self-mixing interferometric sensor. The moving target 9 reflects the electromagnetic radiation such that it is back-coupled into the optical cavity 5 of the VCSEL 1 and superimposed with the undistorted electromagnetic radiation therein. The back-reflected electromagnetic radiation changes the parameters of the active zone 3, leading to a distorted electromagnetic radiation 14 with a frequency variation emitted from the VCSEL 1 during the distorted operation mode. The optical element 10 over the radiation transmission surface 6 facing the detector 11 transmits distorted electromagnetic radiation 14 emitted from this radiation transmission surface 6. The detector 11 detects distorted electromagnetic radiation 14 and produces a SMI-signal.

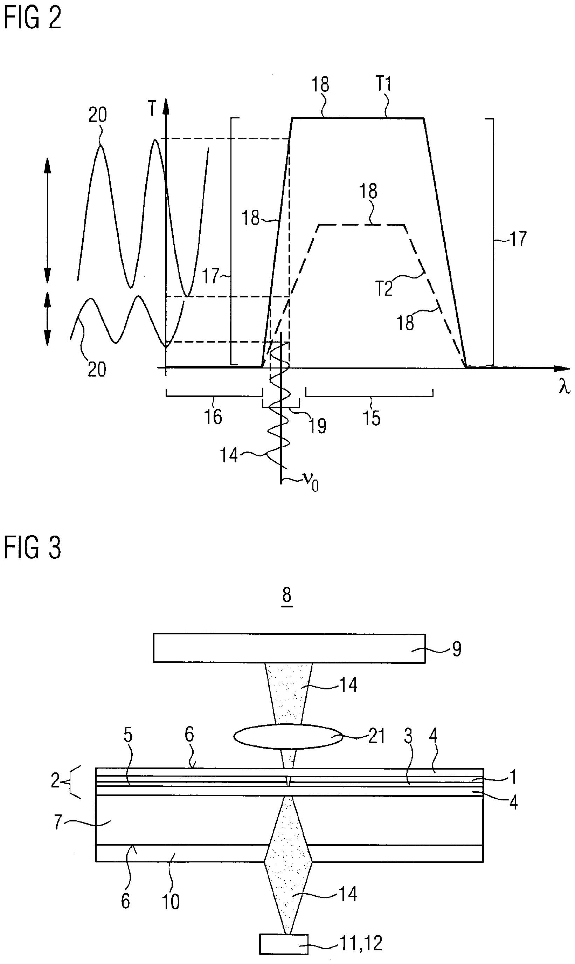

Figure 2 exemplarily shows two transmission spectra T1, T2 of an optical element 10 configured for the use in the self-mixing interferometric sensor according to the exemplary embodiment of Figures 1A and 1B. Particularly, the transmission spectra T1, T2 of Figure 2 each has a transmission region 15, wherein electromagnetic radiation is transmitted and a blocking region 16 blocking electromagnetic radiation, for example by absorption.

The transmission spectra T1, T2 further each has two blocking edges 17 limiting the transmission region 15. For the sake of clarity, only the blocking edges of the transmission spectrum T1 are indicated with reference signs in Figure 2. Further, each blocking edge 17 of each transmission spectrum T1, T2 has a slope 18 connecting the transmission spectrum T1, T2 in the transmission region 15 and transmission spectrum T1, T2 in the blocking region 16. The slope 18 characterizes a transition region 19 of the transmission spectrum T1, T2, wherein electromagnetic radiation is only partially transmitted by the optical element 10 with the respective transmission spectrum T1, T2. The transmission spectra T1, T2 differ in the slope 18 of the transition region 19. The slope 18 of the transmission spectrum T1 is steeper than the slope 18 of the transmission spectrum T2.

Further, in Figure 2 a distorted electromagnetic radiation 14 of the VCSEL 1 of the self-mixing interferometric sensor with a frequency variation impinging on the optical element 10 with the respective transmission spectrum T1, T2 is schematically shown. The varying distorted electromagnetic radiation 14 has frequencies of the blocking edge 17 of the transmission spectrum T1, T2. Particularly, the varying distorted electromagnetic radiation 14 has frequencies of the transmission region 19. The distorted electromagnetic radiation 14 oscillates around an undistorted frequency ν₀ lying in the transition region 19 and being aligned with the blocking edge 17.

The distorted electromagnetic radiation 14 with the frequency variation is converted in electromagnetic radiation 20 with an intensity modulation by the optical element 10 as shown in Figure 2. Particularly, an optical element 10 having a transmission spectrum T1 with a steeper slope 18 of the blocking edge 17 within the transition region 19 coverts the variation of the frequency of the distorted electromagnetic 14 in electromagnetic radiation with a larger modulation of intensity than an optical element 10 having a transmission spectrum T2 with a flatter slope 18 of the blocking edge 17 within the transition region 19. Particularly, an SMI-signal with a larger amplitude modulation is achieved with the optical element 10 having a transmission spectrum T1, T2 with a blocking edge 17 having the steeper slope 18.

Compared to the self-mixing interferometric sensor according to the exemplary embodiment of Figures 1A and 1B, the self-mixing interferometric sensor according to the exemplary embodiment of Figure 3 comprises a lens 21, focusing the electromagnetic radiation back-reflected by the moving target 9.

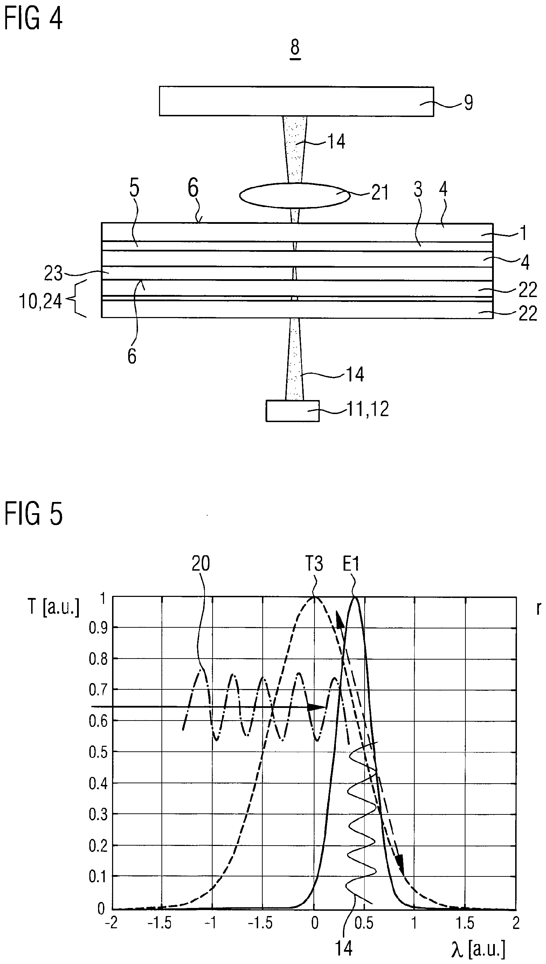

Compared to the self-mixing interferometric sensor according to the exemplary embodiment of Figure 3, the self-mixing interferometric sensor according to the exemplary embodiment of Figure 4 comprises as an optical element 10 a Fabry-Perot interferometer 24 formed by two additional diffractive Bragg reflectors 22 over the radiation transmission surface 6 of the VCSEL 1 facing the detector 11. Particularly, Figure 4 shows the self-mixing interferometric sensor in the distorted operation mode. For example, the detector 11 of the self-mixing interferometric sensor of Figure 4 is a single photodiode 12.

Both diffractive Bragg reflectors 22 of the Fabry-Perot interferometer 24 are epitaxially grown on or over a buffer layer 23 attached to the diffractive Bragg reflector 4 of the optical cavity 5 of the VCSEL 1 facing away from the field of view 8 of the self-mixing interferometric sensor. In other words, the self-mixing interferometric sensor of the exemplary embodiment of Figure 4 has a monolithically integrated optical element 10 embodied as a Fabry-Perot interferometer 24, which is realized by a pair of diffracted Bragg reflectors 22. The monolithically integration of the Fabry-Perot interferometer 22 particularly enables a relative alignment between the undistorted frequency ν₀ of the undistorted electromagnetic radiation 14 emitted by the VCSEL 1 in the undistorted operation mode and the transmission spectrum T1, T2 of the optical element 10 during manufacturing.

Figure 5 shows a transmission spectrum T3 of the optical element 10 of the self-mixing interferometric sensor of Figure 4 and an emission spectrum E1 of the undistorted electromagnetic radiation emitted 13 by the VCSEL 1 in an undistorted operation mode. As shown in Figure 5, distorted electromagnetic radiation 14 with a frequency variation due to a moving target 9 with a motion to be detected arranged within the field of view 8 of the self-mixing interferometry sensor is converted by the optical element 10 to an electromagnetic radiation 20 with an intensity modulation, leading to an enhanced amplitude modulated SMI-signal.

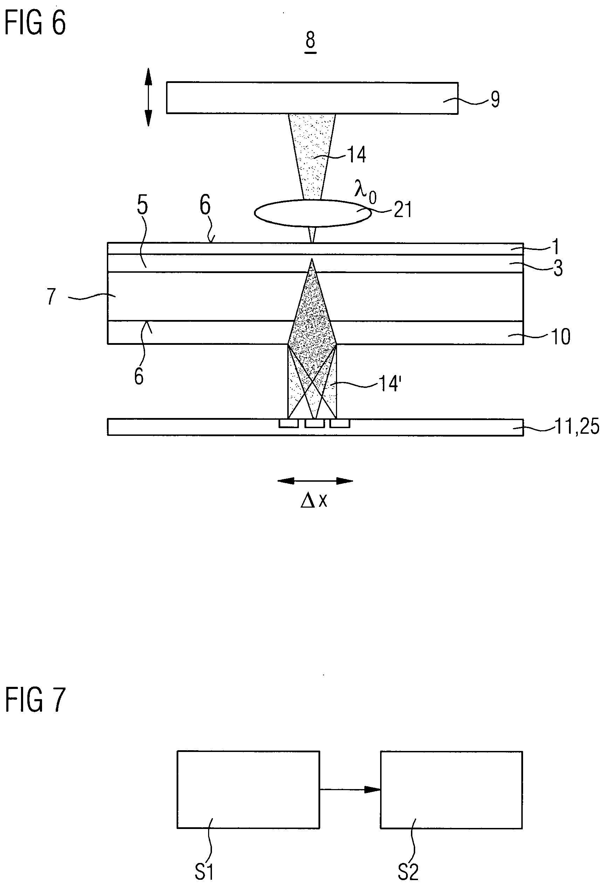

Compared to the interferometric sensor according to Figures 1A, 1B, 3, and 4 the self-mixing interferometric sensor according to the exemplary embodiment of Figure 6 comprises an optical element 10 splitting the distorted electromagnetic radiation 14 emitted to a radiation transmission surface 6 facing away from the field of view 8 of the self-mixing interferometric sensor in different beams 14' dependent on the frequency. In other words, the optical element 10 translates Δν due to the variation in frequency into spatial displacements Δx. Particularly, frequency changes due to the self-mixing interferometric effects in an optical cavity 5 of the VCSEL 1 are converted in different locations x within an optical plane of a spatially resolving detector 25. The spatial displacements Δx are, for example, detected with a photodiode array or a CCD camera. Particularly, this self-mixing interferometric sensor has the advantage that the requirements in terms of wavelength stability are not so high. This reduces manufacturing costs.

During the method for detecting a motion of a moving target 9 according to the exemplary embodiment of Figure 7, a distorted electromagnetic radiation 14 with a frequency variation is generated within an optical cavity 5 of a VCSEL 1 having two radiation transmission surfaces 6 due to the motion of the moving target 9 in a distorted operation mode of a self-mixing interferometric sensor in a first step S1. The distorted electromagnetic radiation 14 with the frequency variation is particularly generated within the optical cavity 5 of the VCSEL 1 of the self-mixing interferometric sensor, if the moving target 9 is arranged within a field of view 8 of the self-mixing interferometric sensor. The moving target 9 back-reflects electromagnetic radiation in the optical cavity 5 such that a variation of the frequency of the electromagnetic radiation of the VCSEL 1 occurs.

In a further, second step S2 of the method, an optical element 10 arranged on or over a radiation transmission surface 6 of the VCSEL 1 transmits the distorted electromagnetic radiation 14 with the frequency variation and blocks undistorted electromagnetic radiation 13 of an undistorted frequency ν₀ of the VCSEL 1. It is also possible that the optical element 10 splits passing distorted electromagnetic radiation 14 in at least two beams 14' dependent on the frequency.

The features and exemplary embodiments described in connection with the Figures can be combined with each other according to further exemplary embodiments, even if not all combinations are explicitly described. Furthermore, the exemplary embodiments described in connection with the Figures may alternatively or additionally have further features according to the description in the general part.

The invention is not limited to the description of the exemplary embodiments. Rather, the invention comprises each new feature as well as each combination of features, particularly each combination of features of the claims, even if the feature or the combination of features itself is not explicitly given in the claims or the exemplary embodiments.

### References

1 VCSEL
2 epitaxial semiconductor layer sequence
3 active zone
4 diffractive Bragg reflector of the VCSEL
5 optical cavity of the VCSEL
6 radiation transmission surface
7 growth substrate
8 field of view of the self-mixing interferometric sensor
9 moving target
10 optical element
11 detector
12 photodiode
13 undistorted electromagnetic radiation
14 distorted electromagnetic radiation
14' beam of distorted electromagnetic radiation
15 transmission region
16 blocking region
17 blocking edge
18 slope
19 transition region
20 electromagnetic radiation with an intensity modulation
21 lens
22 diffractive Bragg reflector of the Fabry-Perot interferometer
23 buffer layer
24 Fabry-Perot interferometer
25 spatially resolving detector
ν₀ undistorted frequency
T1, T2, T3 transmission spectrum
E1 emission spectrum
S1, S2 method step

## Claims

1. Self-mixing interferometric sensor comprising:
- a VCSEL (1) having two radiation transmission surfaces (6) and being configured for emitting undistorted electromagnetic radiation (13) of an undistorted frequency (ν₀) in an undistorted operation mode and configured for emitting distorted electromagnetic radiation (14) with a frequency variation in a distorted operation mode, and
- an optical element (10) on or over one of the radiation transmission surfaces (6), wherein
- the optical element (10) transmits distorted electromagnetic radiation (14) and blocks undistorted electromagnetic radiation (13), and/or
- the optical element (10) splits passing distorted electromagnetic radiation (14) in at least two beams (14') dependent on the frequency.

2. Self-mixing interferometric sensor according to the previous claim, wherein
- the optical element (10) transmits electromagnetic radiation with a frequency smaller than a frequency of a blocking edge (17) and absorbs electromagnetic radiation with a frequency larger than the frequency of the blocking edge (17) or vice versa, and
- the undistorted frequency (ν₀) of the undistorted electromagnetic radiation 13 is aligned with the blocking edge (17).

3. Self-mixing interferometric sensor according to any of the previous claims, wherein
the undistorted frequency (ν₀) of the undistorted electromagnetic radiation (13) corresponds to a frequency of a slope (18) of the blocking edge (17).

4. Self-mixing interferometric sensor according to any of claims 2 to 3, wherein
- a transmission spectrum (T1, T2, T3) of the optical element (10) has a further blocking edge (17), and
- the blocking edge (17) and the further blocking edge (17) limit a transmission region (15) of the optical element (10) for distorted electromagnetic radiation (14) with the frequency variation of the VCSEL (1).

5. Self-mixing interferometric sensor according to any of the previous claims, wherein
the optical element (10) is chosen from the following group: Fabry-Pero interferometer (24), metasurface, volume phase hologram, interference filter, diffractive optical element.

6. Self-mixing interferometric sensor according to any of the previous claims, wherein
the optical element (10) is applied to one of the radiation transmission surfaces (6) of the VCSEL (1).

7. Self-mixing interferometric sensor according to the previous claim, wherein
the optical element (10) comprises two diffractive Bragg reflectors (22) applied to one of the radiation transmission surfaces (6) of the VCSEL (1), the two diffractive Bragg reflectors (22) forming a Fabry-Pero interferometer (24).

8. Self-mixing interferometric sensor according to the previous claim, wherein
the two diffractive Bragg reflectors (22) are epitaxially grown on a buffer layer (23) arranged on a further Bragg reflector (4) forming partially an optical cavity (5) of the VSCEL (1).

9. Self-mixing interferometric sensor according to any of the previous claims,
further comprising a detector (11) configured for detecting distorted electromagnetic radiation (14) leaving the optical element (10).

10. Self-mixing interferometric sensor according to the previous claim, wherein
the detector (11) is a photodiode (12) directly applied to the optical element (10).

11. Self-mixing interferometric sensor according to any of the previous claims, further comprising a spatially resolving detector (25).

12. Self-mixing interferometric sensor according to the previous claim, wherein
the spatially resolving detector (25) is a photodiode array or a CCD camera.

13. Method for detecting a motion of a moving target, wherein
- a distorted electromagnetic radiation (14) with a frequency variation is generated within a cavity (5) of a VCSEL (1) having two radiation transmission surfaces (6) due to the motion of the moving target (9) in a distorted operation mode of a self-mixing interferometric sensor, and
- an optical element (10) arranged on or over one of the radiation transmission surfaces (6) transmits the distorted electromagnetic radiation (14) and blocks undistorted electromagnetic radiation (13) of an undistorted frequency of the VCSEL (1) in an undistorted operation mode of the self-mixing interferometric sensor and/or splits passing distorted electromagnetic radiation (14) in at least two beams (14') dependent on the frequency.

14. Method according to the previous claim, wherein
the distorted electromagnetic radiation (14) leaving the optical element (10) is detected by a detector (11).
